# EUROPEAN PATENT SPECIFICATION

(11) **EP 2 169 139 B1**
(45) Date of publication and mention of the grant of the patent: **27.01.2016**
(21) Application number: 07828390.0
(22) Date of filing: 26.09.2007
(51) Int. Cl.: F24J 2/52, H02S 20/23

(54) **FIXING STRUCTURE OF SOLAR BATTERY MODULE, FRAME FOR THE SOLAR BATTERY MODULE, AND FIXING MEMBER**
BEFESTIGUNGSSTRUKTUR FÜR EIN SOLARBATTERIEMODUL, RAHMEN FÜR DAS SOLARBATTERIEMODUL UND BEFESTIGUNGSELEMENT
STRUCTURE DE FIXATION D'UN MODULE DE BATTERIE SOLAIRE, CADRE POUR LE MODULE DE BATTERIE SOLAIRE, ET ÉLÉMENT DE FIXATION

(30) Priority: 11.06.2007 JP 2007153463
(43) Date of publication of application: 31.03.2010
(73) Proprietor: Yanegijutsukenkyujo Co. Ltd., Takahama-shi, Aichi 444-1324 (JP)
(72) Inventor: KOBAYASHI, Shuichi, Takahama-shi Aichi 444-1324 (JP)
(74) Representative: Müller Schupfner & Partner Patent- und Rechtsanwaltspartnerschaft mbB
(86) International application number: PCT/JP2007/068617
(87) International publication number: WO 2008/152748

(56) References cited:
- EP-A2- 0 587 348
- JP-A- 2003 056 131
- JP-A- 2003 278 333
- JP-B1- 3 455 210
- JP-B2- 3 475 781

## Description

### FIELD OF THE INVENTION

This invention relates to a retaining structure that fastens a solar cell module on a roof, and a frame and a holding member for the solar cell module.

### BACKGROUND OF THE INVENTION

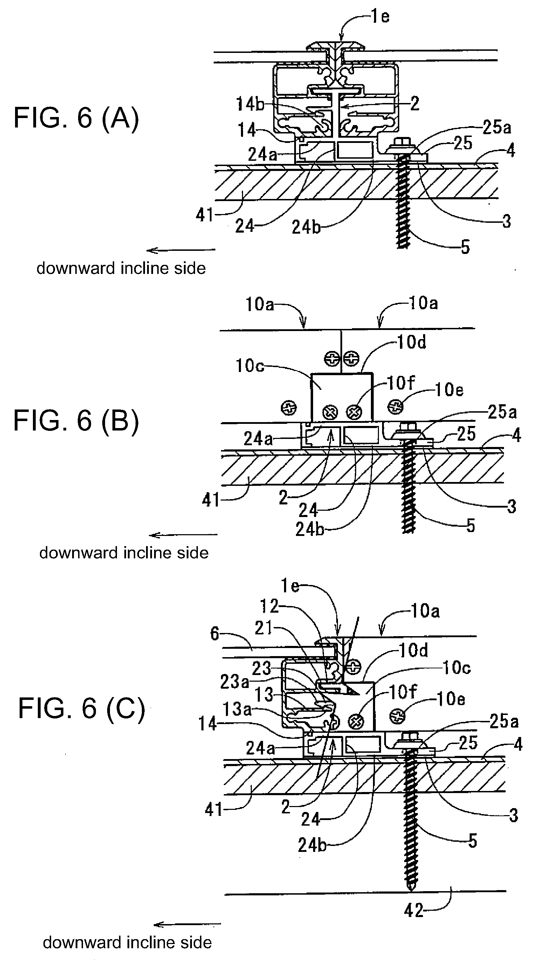

A solar cell module retaining structure to be installed directly onto a sheathing slope without using a roof material is known as a conventional retaining structure for solar cell modules. For example, as shown in FIG. 6(A), a sway brace 82 is formed on an upward incline side frame 81 of the downward incline side solar cell module of two frames 80, 81 of two adjacent solar cell modules extending perpendicularly relative to a downward incline direction, and the sway brace 82 is tied to a sheathing slope 41 while an upward incline side fitting portion 84 formed on the upward incline side frame 81 of the downward incline side solar cell module fits with an upward fitting portion 83 formed on the downward incline side frame 80 of the upward incline side solar cell module (Patent Document 1).

As shown in FIG. 6(B) and FIG. 6(C), the other solar cell module retaining structure is such that two adjacent solar cell module frames 92 of the solar cell modules are installed on a mounting base 90 at the same time. An installation portion 93 of the frame 92 fits by sliding an installation portion 91 of the mounting base 90, and the mounting base 90 is installed on a rafter by a bolt 95 (Patent Document 2).

[Patent Document 1] Provisional Patent Publication No. 2000-297509 [Patent Document 2] Provisional Patent Publication No. 2003-336357

### DISCLOSURE OF THE INVENTION

### PROBLEMS TO BE RESOLVED BY THE INVENTION

However, in the conventional solar cell module retaining structure as described in the Patent Document 1, since the sway braces 82 for the installation of the frame 81 on the sheathing slope 41 are integrally arranged with a predetermined incline, the predetermined positions of the rafters supporting the sheathing slope 41 do not match the positions of the sway braces 82 of the solar cell modules, and the sway braces 82 are not fastened on the rafters properly, thereby creating a chance of reducing the strength of solar cell module attachment.

Also, the shapes of the downward incline side frame 80 and the upward incline side frame 81 of the solar cell module are different, which increases the number of members and requires more complex processing to form the sway braces 82, increasing the cost of manufacturing.

In the conventional solar cell module retaining structure as shown in Patent Document 2, since the installation portion 91 of the mounting base 90 is positioned between the frame 92 and the frame 92, an installation area of the solar cell module increases, which decreases the number of solar cell modules that could be installed. Furthermore, since space between the frame 92 and the frame 92 is open, a member, such as a cover, that covers a surface, such as the mounting base 90, is necessary in order to improve the design, which increases the cost of manufacturing.

Then, considering the descriptions above, by reducing the number of members relating to the solar cell module retaining structure and standardizing the installation process, this invention provides the solar cell module retaining structure, solar cell module frame, and the holding member which reduces the cost of manufacturing and installation and improve the design thereof.

JP 3 475 781 B2 discloses a mounting system for installing an array of solar battery modules of a panel-like configuration on a roof. The system includes a plurality of vertical rails which are secured to the roof and extend along a roof sloping direction towards eaves from a ridge of the roof for holding the solar battery modules between a laterally spaced pair of vertical rails in a spaced relation from a roof sheathing. Each of the vertical rails is formed on opposite sides thereof respectively with stepped shoulders which extend the full length of the vertical rail for supporting thereon the frame of the laterally adjoining solar battery modules. The vertical rail is further formed on opposite sides thereof with respective trough sections which extend the full length of the vertical rail and are disposed below and outwardly of the corresponding stepped shoulders for receiving the rainwater sneaking along the frame.

### MEANS TO RESOLVE THE PROBLEMS

The invention consists of a solar cell module retaining structure for fastening a solar cell module to a supporting member according to claim 1.

According to this invention, the solar cell module retaining structure, with a solar cell module, which has a flat polygon solar cell panel body with a solar cell and frames adjacent to the solar cell panel body fastened to at least one pair of facing sides thereof, fastened to a supporting member by connecting each holding member to frames at each facing side of the solar cell module, wherein the holding members have the ability to slide relative to the frames, attach the frames of two solar cell modules arranged in an extending direction of the supporting member to arrange the solar cell modules to make an almost flush surface, restricts one of the two solar cell modules to move in a right-angle direction relative to an extending direction of the frames, and is fastened to the supporting member at the lower side of the solar cell module; the frame, extended lengthwise in a cross-section, is comprised of an insertion support portion which has an opening at the first side surface side and into which a peripheral portion of the solar cell panel body is inserted and supported, a connection portion which is arranged at a lower side of the insertion support portion and has an opening at the second side surface side which is opposite side the first side surface, and an engagement protrusion which is arranged at a lower side of the connection portion and has an opening at the second side surface side that projects upward; and the holding member is comprised of a pair of connecting portions which can be inserted in the connection portion and extend in a direction away from each other, a down section extending downward from the pair of the connecting portions, a seat section arranged at the lower end of the down section and capable of mounting a bottom of the frame thereon, an engagement piece having an engagement protrusion portion positioned between the seat section and the connecting portion and extending from the down section in the same direction as the connecting portion to project an end downward so as to engage the engagement protrusion section, and a holding portion with a lower surface on the same surface as the lower surface of the seat section and extending in an opposite direction of the engagement piece extension so as to be fastened to the supporting member, and is designed to have the same cross-section shape and be shorter than the frame.

Here, the supporting member is a roof structure member, such as a sheathing slope and rafter for timber constructions, and a main house for steel frame buildings which should be able to sufficiently maintain the required strength thereof.

According to this invention, this invention is a solar cell module retaining structure, with a solar cell module, which has a flat polygon solar cell panel body with a solar cell and frames adjacent to said solar cell panel body fastened to at least one pair of facing sides thereof, fastened to a supporting member by connecting each holding member to frames at each facing side of the solar cell module, wherein the holding members have the ability to slide relative to the frames, attach the frames of two solar cell modules arranged in an extending direction of the supporting member to arrange the solar cell modules to make an almost flush surface, restricts one of the two solar cell modules so that it moves in a right-angle direction relative to an extending direction of the frames, and is fastened to the supporting member at a lower side of the solar cell module.

As such, the holding member is connected to the frame, and the holding member can be supported by the supporting member. Also, since the holding member is designed to have the ability to slide relative to the frame, when fastened onto the sheathing slope of the roof for example, the holding member can be slid to one position where there is a supporting member (structural members) such as a rafter, which is supporting the sheathing slope with the predetermined interval, and the holding member is installed in a position so that is firmly installed, thereby fastening the solar cell module even firmer.

Also, after fastening one solar cell module to the supporting member by the holding member via the frames, the frame of the other solar cell module can be fastened by the holding member so that plurality of solar cell modules may be fastened in order in one direction, which helps to establish the installation standard and reduce the cost of manufacturing. Also, when the holding member is fastened to the supporting member, since a portion of the holding member to be fastened to the supporting member is being fastened to the supporting member at the lower side of the other solar cell module, the frames come in contact with each other. Furthermore, the solar cell modules are arranged to make an almost flush surface, thereby eliminating a clearance between the solar cell modules, which improves the design, and eliminates an unnecessary members such as a cover.

Also, since the frames of the solar cell modules arranged adjacent to each other are connected to each other, as long as the solar cell modules are the same size, an installation surface of the solar cell module can be minimized, thereby preventing the reduction of the number of installations of solar cell modules on roofs, etc. Furthermore, because the frames are designed to have matching cross-section surfaces with two facing sides of the solar cell module, the frames with different cross-section surface shapes as shown in Patent Document 1 are not necessary for the solar cell module to be fastened to the supporting member, which reduces the number of parts, cutting down the manufacturing cost of the solar cell module retaining structure.

Also, as stated above, the same frames can be fastened to all sides of the solar cell panel body, or the frames are fastened to a pair of facing sides and frames with a different cross-section shape (for example, a side surface frame) can be fastened to the sides orthogonal to the sides fastened to the frames.

The solar cell module retaining structure relating to this invention, in addition to the above-mentioned structure, is characterized in that the other solar cell module is placed on a roof slope on a downward incline side thereof with the holding member in between.

The solar cell module according to this invention is such that the other solar cell module is placed on the roof slope on the downward incline side thereof with the holding member in between. That is, the holding member which fastens the downward incline side of the upward incline side of the solar cell module is used to fasten the downward incline side of the solar cell module placed on the upward incline side thereof.

As such, the upward incline side of the solar cell module is fastened relative to the holding member, which fastens the downward incline side of the solar cell module, and because of the deadweight of the solar cell module, it can be fastened easily, and the upward incline of the solar cell module can also be fastened by the holding member, thereby completely fastening the solar cell module. Accordingly, multiple solar cell modules can be fastened in order from the downward incline side to the upward incline side, and the standardization of the installation and installation cost reduction becomes possible.

In addition, the above-mentioned solar cell module retaining structure, as a solar cell module installation method, first has the holding member as a starter fixture that can be fastened onto the downward incline side of the roof or the supporting member, and the frame on one side of the solar cell module is connected with the holding member (starter fixture). Here, a decorative cover of the holding member can be fastened on the downward incline side of the holding member. As such, this gives a feeling of integrity with the roof and improves the design. Then, for the solar cell module, the holding member is connected to the side (downward incline side) opposite to the side where the starter fixture is connected. There, a portion of the holding member fastened to the supporting member of the holding member is connected to the frame of the solar cell module so as to face the direction of the side (downward incline side) opposite to the solar cell module. Then, the holding member is slid relative to the frame, and the holding member is fastened to the structural members, such as the rafter of the supporting member. Next, relative to the holding member which fastens the first solar cell module, the second solar cell module is connected to the downward incline side thereof. Accordingly, two adjacent frames of the solar cell modules are in contact with each other, and the holding members are fastened to the supporting members on the lower side of two solar cell module. Afterward, the holding member is fastened to the frame on the other side (downward incline side) in the second solar cell module, and as stated above, the holding member is fastened to the supporting member so as to completely fasten the second solar cell module, wherein the above-mention operation can be repeated to fasten the solar cell modules to the supporting members in order toward the downward incline side. Accordingly, according to the solar cell modules of this invention, relative to the supporting member, multiple solar cell modules can be fastened in order in one direction from a certain point (for example, the starter fixture), and the standardization of the installation and installation cost reduction becomes possible.

### (Canceled)

According to this invention, in the solar cell module retaining structure, the frame is comprised of an insertion support portion which has an opening at the first side surface side and into which a peripheral portion of the solar cell panel body is inserted and supported, a connection portion which is arranged at a lower side of the insertion support portion and has an opening at the second side surface side which is opposite the first side surface, and an engagement protrusion which is arranged at a lower side of the connection portion and has an opening at the second side surface side that projects upward, and the holding member is comprised of a pair of connecting portions which can be inserted in the connection portion and extend in a direction away from each other; a down section extending downward from the pair of the connecting portions; a seat section arranged at the lower end of the down section and capable of mounting a bottom of the frame thereon, an engagement piece having an engagement protrusion portion positioned between the seat section and the connecting portion and extending from the down section in the same direction as the connecting portion to project an end downward so as to engage the engagement protrusion section; and a holding portion with a lower surface on the same surface as the lower surface of the seat section and extending in an opposite direction of the engagement piece extension so as to be fastened to the supporting member, and is designed to have the same cross-section shape and be shorter than the frame.

As such, by using the insertion support portion of the frame, a conventional module glass (solar cell panel body) with solar cells necessary for generating electricity can be inserted and supported. Also, the connection portion is opened at the lower side of the insertion support portion and at the other side surface side opposite to the first side surface side so as to be able to connect to the connecting portion, thereby preventing the solar cell module from disengaging from the roof due to wind load and earthquake load, etc. Also, engagement between the engagement protrusion and the engaging protrusion arranged at the lower side of the connection portion prevents the frame and the holding member from disengaging. Furthermore, the holding member is designed shorter than the frame, and the holding member can slide freely as long as it is shorter than the frame. Accordingly, the holding member is slid relative to the frame when installed, and the holding member can easily be fastened to the structural members, such as the rafter of the supporting member. Furthermore, for example, an arrow-shaped engagement protrusion and engaging protrusion have a strong engagement force, wherein the holding member can engage with the frame as necessary when installed.

In addition, the holding member for fastening the supporting member extends from the seat section, and the holding section can be fastened to the structural members, such as the rafter on the supporting member, thereby preventing the solar cell module from disengaging from the roof due to an external force transmitted through the frames. Also, during installation, in order to place the holding member on the downward incline side of the solar cell module and fasten it to the supporting member, the holding member extends in the opposite direction of the extending direction of the engagement piece, and therefore, when fastening the holding member to the supporting member by fasteners such as bolts, the holding member, frame, and solar cell module do not interfere with installation tools, which increases installation efficiency of the device.

The solar cell module retaining structure relating to this invention, in addition to the above structures, is characterized in that the frame has an upper portion at an open side of the connection portion thereof that inclines, and the holding member has a portion that inclines at the lower side of an end of the connecting portion.

According to this invention, in the solar cell module retaining structure, the frame has an upper portion at an open side of the connection portion thereof that inclines, and the holding member has a portion that inclines at the lower side of an end of the connecting portion.

Accordingly, the connecting portion of the holding member and the connection portion of the frame incline so that the other side of the solar cell module, when connecting the connecting portion to the connection portion, is set higher and diagonal so as to be able to prevent interference between the connecting portion and the connection portion while inserting the connecting portion into the opening of the connection portion, and to connect the diagonal solar cell module, thereby facilitating the installation process and reducing the cost of the manufacturing process.

The solar cell module retaining structure relating to this invention is characterized in that the solar cell module further comprises a side surface frame that is fastened to a side different from a side where the frame is fastened around the solar cell panel body, has a notched groove through which the holding member can pass, and a side surface cap that covers the notched groove of the side surface frame and is fastened to the frame, wherein by removing the side surface cap while the holding member is supported by the supporting member, the solar cell module fastened by the holding member can be slid in an extending direction of the frame to remove the solar cell module from the holding member.

Here, when the holding member is designed to fasten and support the supporting members such as the roof, etc. using the fasteners such as bolts, there is a possibility of water leakage, such as rain passing through the fasteners to be fastened on the supporting member from the front surface to the back surface of the supporting member. In addition, there is a possibility of the fasteners becoming unstable due to the convex-concave shape of the surface of the supporting member, such as a roof, and unable to firmly fasten the frame of the solar cell module due to the inclination thereof. As such, a waterproof rubber made of butyl rubber, etc. can be used between the holding member and the supporting member which stops leakage and fills in the gaps of the convex-concave surfaces of the supporting member. However, in this case, when conducting a maintenance job of the solar cell module, if the holding member is disengaged from the supporting member such as a roof to remove the solar cell module, there is a possibility of breaking the roof material with the waterproof rubber attached to the lower side of the holding member when pealing the holding member from the roof material. Furthermore, removal of the fastener for fastening the holding member increases the risk of leakage from that spot, and at the same time reduces the strength of the fastener when fastening the holding member with the fastener at the original location (same location).

The solar cell module retaining structure relating to this invention is characterized in that the solar cell module further comprises a side surface frame that is fastened to a side different from a side where the frame is fastened around the solar cell panel body, has a notched groove through which the holding member can pass, and a side surface cap that covers the notched groove of the side surface frame and is fastened to the frame, wherein by removing the side surface cap while the holding member is supported by the supporting member, the solar cell module fastened by the holding member can be slid in an extending direction of the frame to remove the solar cell module from the holding member.

As such, since the side surface frame has the notched groove of the appropriate size without interfering with the frame and holding member, after installing the solar cell module, the solar cell module can be removed without disengaging the holding member from the roof while conducting maintenance operation, which provides the maintenance operation with a dramatically reduces the risk of breaking the roof material due to the removal of the holding member from the roof material and the risk of leakage. Also, since the solar cell module can be removed without disengaging the holding member, the solar cell module can be firmly fastened after maintenance and the process can be repeated without reducing the strength of the connection between the holding member and the supporting member, such as roof material, by the fastener. Here, the side surface frame can have the same cross-section shape as the frame or be different from the cross-section shape.

Also, since the solar cell modules arranged close to each other can be coupled by the side surface cap, the frames, side surface cap, and side surface cap of the solar cell module are fastened to the frame using a metal fastener such as a screw so that one solar cell module and the adjacent other solar cell module can be electrically communicatable via the side surface cap and the metal fastener. Accordingly, when installing groundings between the solar cell modules, there is no need to separately install the cables for groundings and prepare additional parts for the groundings. The solar cell modules can easily be connected each other, which reduces the cost in relation to the grounding. Also, in addition to the connection of the holding member, adjacent solar cell modules can be coupled by the side surface caps, and if by chance a part of the holding member becomes disengaged from the supporting member, the solar cell module is coupled to the other solar cell module fastened to the supporting member by the side surface caps, which prevents the solar cell module from falling off the roof material, such as the supporting member, and prevents collateral damages.

### (Canceled)

According to this invention, the frame is for a solar cell module retaining structure with a solar cell in a solar cell module and is fastened to at least one pair of facing sides around a flat polygon solar cell panel body, comprising an insertion support portion which has an opening at the first side surface side and into which a peripheral portion of the solar cell panel body is inserted and supported, a connection portion which is arranged at a lower side of the insertion support portion and has an opening at the second side surface side at an opposite side of the first side surface, an engagement protrusion which is arranged at a lower side of the connection portion and has an opening at the second side surface side that projects upward, and a frame that is extended lengthwise in a cross-section.

As such, by using the insertion support portion of the frame, a conventional module glass (solar cell panel body) with solar cells necessary for generating electricity can be inserted and supported. Also, the connection portion is open at the lower side of the insertion support portion, and the connecting portion of the holding member to be fastened to the supporting member via the connection portion is connected so as to fasten the frame to the supporting member, thereby preventing the solar cell module from disengaging from the roof due to wind load and earthquake load, etc. Also, the engagement protrusion is arranged at the lower side of the connection section, and by engaging the engaging protrusion of the holding member with the engagement protrusion disengagement of the frame from the holding member at the installation process can be avoided. Accordingly, the frame can be more firmly fastened to the supporting member. Furthermore, cross-section shapes of the frames are the same and are extended lengthwise, and therefore, the frames can easily be made by extrusion, etc., which reduces the cost of manufacturing the frames.

The holding member of the solar cell module retaining structure relating to this invention is characterized in that the holding member for the solar cell module fastens the solar cell module to a predetermined supporting member via the frames, to be fastened to at least one pair of facing sides around a flat polygon solar cell panel body with a solar cell in a solar cell module, the frame extended lengthwise in a cross-section and comprising an insertion support portion which has an opening at the first side surface side and into which a peripheral portion of the solar cell panel body is inserted and supported, a connection portion which is arranged at a lower side of the insertion support portion and has an opening at the second side surface side at an opposite side of the first side surface, and an engagement protrusion which is arranged at the lower side of the connection portion and has an opening at the second side surface side that projects upward, wherein the holding member is comprised of a pair of connecting portions which can be inserted in the connecting section and extending in a direction away from each other; a down section extending downward from the pair of the connecting portions; a seat section arranged at the lower end of the down section and capable of mounting a bottom of the frame thereon, an engagement piece having an engagement protrusion portion positioned between the seat section and the connecting portion and extending from the down section in the same direction as the connecting portion to project an end downward so as to engage the engagement protrusion section; and a holding portion having a lower surface on the same surface as the lower surface of the seat section and extending in an opposite direction of the engagement piece extension so as to be fastened to the supporting member, and is designed to have the same cross-section shape and be shorter than the frame.

According to this invention, the holding member of the solar cell module retaining structure fastens cell module to a predetermined supporting member via the frames, wherein the holding member is comprised of a pair of connecting portions which can be inserted in the connecting section and extending in a direction away from each other; a down section extending downward from the pair of the connecting portions; a seat section arranged at the lower end of the down section and capable of mounting a bottom of the frame thereon, an engagement piece having an engagement protrusion portion positioned between the seat section and the connecting portion and extending from the down section in the same direction as the connecting portion to project an end downward so as to engage the engagement protrusion section; and a holding portion having a lower surface on the same surface as the lower surface of the seat section and extending in an opposite direction of the engagement piece extension so as to be fastened to the supporting member, and is designed to have the same cross-section shape and be shorter than the frame.

As such, by connecting the connecting portion of the holding member to the connection portion of the frame, the solar cell module can be fastened via the frames, thereby preventing the solar cell module from disengaging from the roof due wind load and earthquake load, etc. Also, engagement between the engagement protrusion and the engaging protrusion prevents the frame and the holding member from being disengaged. Also, the holding member has a pair of connecting portions and the connection portions both extend in the direction away from each other, and by inserting and connecting the connection portion of the respective frame to the pair of connecting portions, the frames with the same cross-section shapes can be connected without problems.

Also, the holding member is designed shorter than the frame, and therefore, the holding member can slide freely as long as it is shorter than the frame, and by sliding the holding member relative to the frame in the installation process, the structure member such as the rafter in the supporting member can easily be fastened to the holding member. Also, the holding member for fastening the supporting member extends from the seat section, and the holding section can be fastened to the structural member such as the rafter at the supporting member, thereby preventing the solar cell module from disengaging from the roof due to an external force transmitted through the frames. Also, since the holding member to be fastened to the supporting member extends in the direction opposite to the extending direction of the engagement piece, when the holding portion of the holding member is fastened by fasteners such as bolts, with the solar cell module frame connected to the side with the engagement piece relative to the connecting portion, interference of the solar cell module to be fastened by installing tools, etc. can be avoided. Furthermore, the cross-section shapes of the holding members are the same and are extended lengthwise, and therefore, the holding member can be easily made by extrusion and cutting at the proper length, etc., which reduces the cost of manufacturing the frames.

In addition to the above structures, the holding member for the solar cell module of this invention is characterized in that the holding member is designed such that the seat section extends farther than the extension of the connecting portion.

According to this invention, the holding member is such that the seat section extends farther than the extension of the connecting portion.

Accordingly, in the installation process of the solar cell module, after the bottom portion of the frame is mounted on the upper portion of the seat section, when the other solar cell module is connected to the holding member fastening one solar cell module, the solar cell module is slid in the direction of the downward portion of the holding member to connect the connection portion of the frame and the connecting portion of the holding member, and at that time, since the seat section of the holding member is longer than the extension of the connecting portion, the bottom portion of the frame can be easily mounted on the seat section, which improves installation efficiency.

In addition to the above described structures, the holding member of the solar cell module of this invention is characterized in that the height of the holding member is designed for the seat section to sufficiently form a clearance between the lower surface of the frame and the supporting member, through which a module cable connected to the solar cell panel body can pass, and the upper surface of the solar cell module body is adjustable so that height thereof is approximately equal to a roof material mounted on the supporting member.

According to this invention, the holding member is such that the height thereof is designed for the seat section to sufficiently form a clearance between the lower surface of the frame and the supporting member, through which a module cable connected to the solar cell panel body can pass, and the upper surface of the solar cell module body is adjustable so that height thereof is approximately equal to a roof material mounted on the supporting member.

As such, the height adjustment can be done by the adjacent roof materials using the seat sections of the holding members. For example, a flat roof made from asphalt shingles or straight roof materials can be arranged to be lowered for a module cable or cable connecter to pass through, and the distance/height between the roof material and the bottom surface of the frame can be in the range of 5 mm - 20 mm (e.g., 7 mm). Also, the surfaces of the adjacent roof materials and the frames can have approximately the same height when the roof materials are thicker, such as roof tiles. Adjustment of the height provides the feeling of integrity with the building/house and improves the design thereof.

### ADVANTAGES OF THE INVENTION

As stated above, according to this invention, by reducing the number of members relating to the solar cell module retaining structure and standardizing the installation process, this invention provides the solar cell module retaining structure, solar cell module frame, and the holding member which reduce the cost of manufacturing and installation.

### BRIEF DESCRIPTION OF THE DRAWINGS

FIG. 1 is a cross-section view of one embodiment of this invention showing the frames for the solar cell modules and the solar cell module retaining structure using the holding members;
FIG. 2 is an enlarged cross-section view of the enlarged A in FIG. 1;
FIG. 3 (A) is a side surface view of FIG. 2; FIG. 3 (B) is a side surface view of the side surface frames and side surface caps different from FIG. 3 (A); FIG. 3 (C) is a side surface view of one portion FIG. 3 (B) in a cross-section;
FIG. 4 is an explanation view of the installation process summary for the solar cell module in FIGS. 1 and 2;
FIG. 5 (A) is a perspective view of the condition where the solar cell module is installed on the roof material using the solar cell module retaining structure as shown in FIG. 1; FIG. 5 (B) is a perspective view of the condition where the height of the solar cell module and the adjacent roof material are approximately the same using the solar cell module retaining structure as shown in FIG. 1;
FIG. 6 is a cross-section of the solar cell module retaining structure of this invention using the frame and the side surface cap with different cross-sections from the FIG. 2 and FIG. 3;
FIG. 7 is a perspective cross-section view of the frame and the holding member for the solar cell module of another embodiment of this invention;

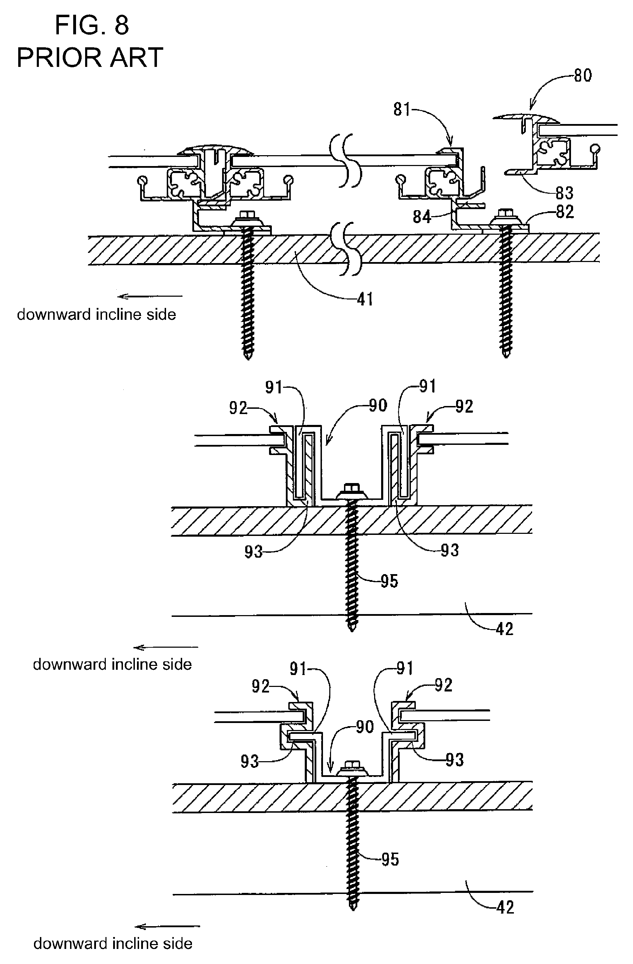

FIG. 8 is a perspective cross-section view of an example of the conventional solar cell module.

### PREFERRED EMBODIMENTS OF THE INVENTION

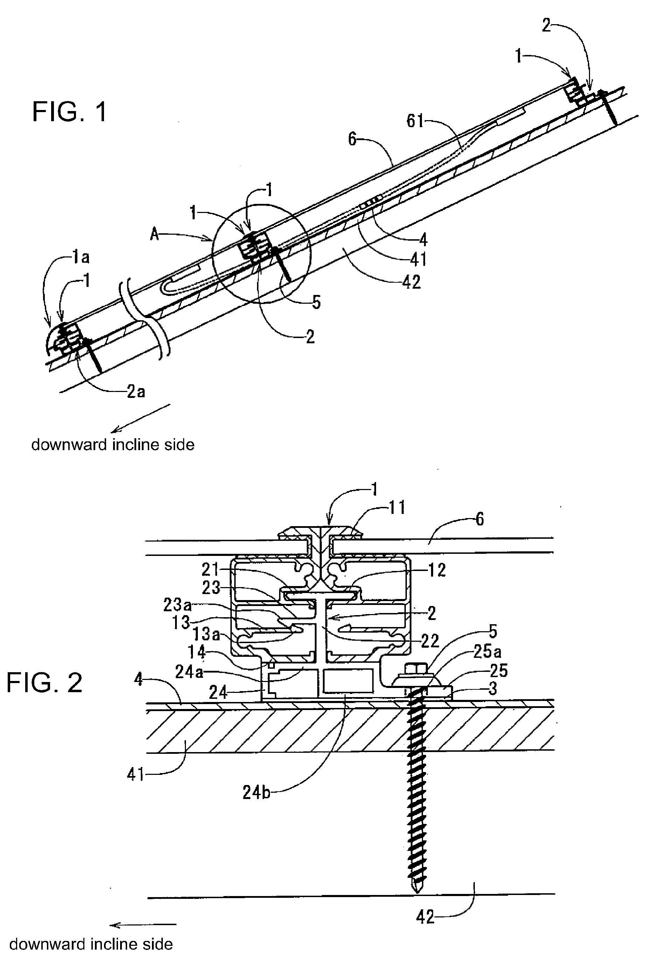

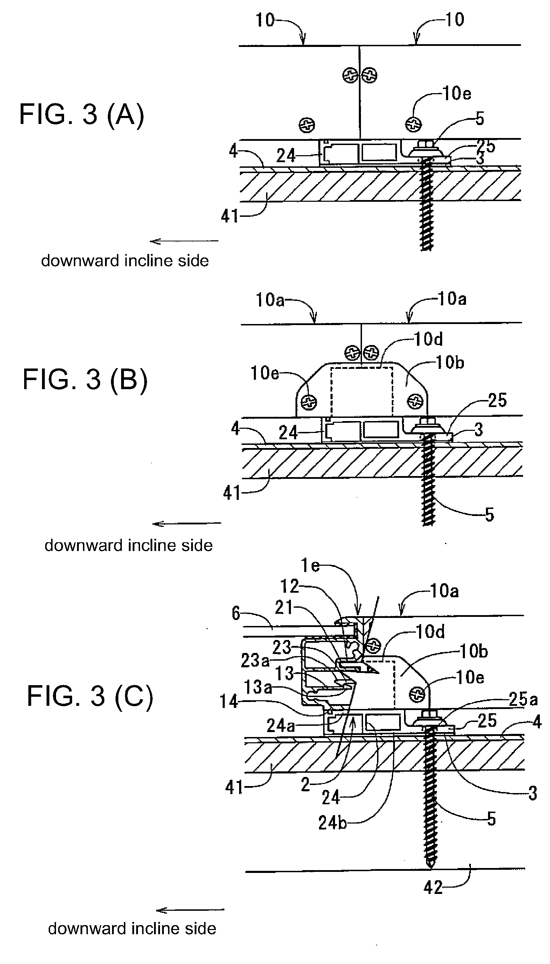

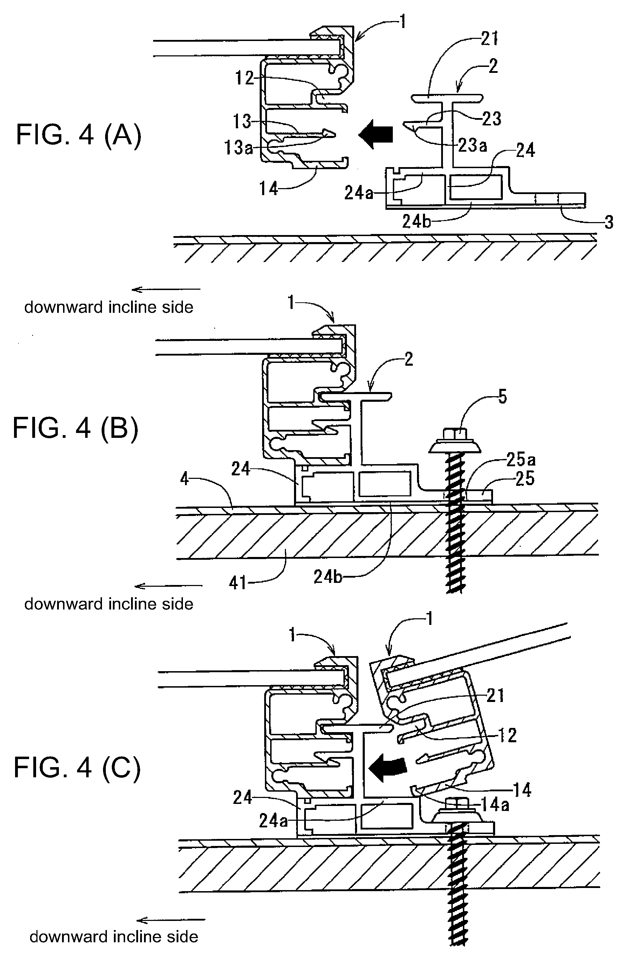

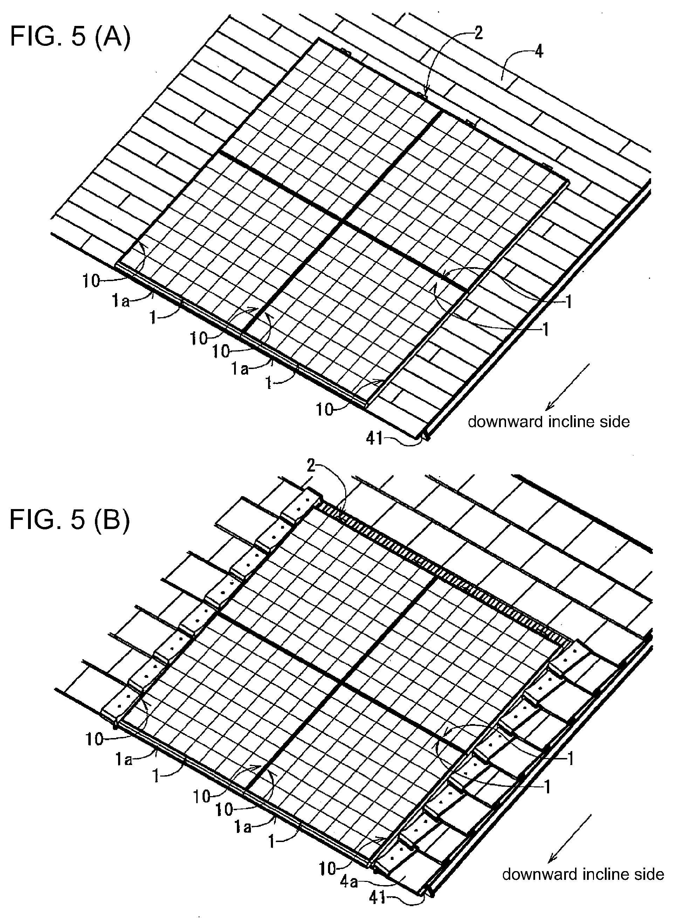

In the following sections, preferred embodiments of this invention for the solar cell module retaining structure, frames for the solar cell modules, and holding members for the solar cell modules will be explained with reference to FIGS. 1-5. FIG. 1 is a cross-section view of one embodiment of this invention showing the frames for the solar cell modules and the solar cell module retaining structure using the holding members. FIG. 2 is an enlarged cross-section view of the details of A in FIG. 1. FIG. 3 (A) is a side surface view of FIG. 2; FIG. 3(B) is a side surface view of the side surface frames and side surface caps different from FIG. 3 (A); and FIG. 3 (C) is a side surface view of one portion FIG. 3 (B) in a cross-section. FIG. 4 is an explanation view of the installation process summary for the solar cell module in FIGS. 1 and 2. FIG. 5 (A) is a perspective view of the condition where the solar cell module is installed on the roof material using the solar cell module retaining structure as shown in FIG. 1; and FIG. 5 (B) is a perspective view of the condition where the height of the surface of the solar cell module and the adjacent roof material are the same using the solar cell module retaining structure as shown in FIG. 1.

In the solar cell module retaining structure utilizing a frame 1 and a holding member 2 for the solar cell module of this embodiment, as shown in FIG. 1, the frame 1 can be slid into a position of supporting member 42, such as a rafter, which supports a sheathing slope 41 with a predetermined interval and is completely fastened by the holding member 2 using a fastener 5 such as a bolt. The frames 1 adjacent to two solar cell modules positioned in an extending direction of the supporting member 42 are in contact with each other and are connected to make an almost flush surface. Also, this example uses a cosmetic cover 1a which improves the design of the solar cell module on a downward incline side (solar cell array).

More specifically, as shown in FIGS. 2 and 4 (A), a cross-section shape of the frame 1 for the solar cell module has a rectangle portion with a rectangle bottom surface arranged around middle section thereof relative to the height of the frame 1; a C-shaped insertion support portion 11 formed on the right surface thereof which has an opening at the first side surface side and into which an end of a module glass 6 in a solar cell panel body is inserted and supported; and a connection portion 12 formed and opened at the other side surface side opposite to the first side surface side around a lower right internal portion of the rectangular shape. Then, there is an L-shaped bottom portion 14 which extends from the first side surface side of the rectangular to a lower side thereof, and then to the other side surface side. Furthermore, an engagement protrusion 13 has an arrow-shaped end portion 13a around the center of the connection portion 12 and the bottom portion 14, which extends in the same direction as the bottom portion 14 and has a top projecting upward. Also, a publicly known sealing member is placed between the end of the module glass 6 and the insertion support portion 11.

Also, as shown in the illustrations, the other side surface side of the frame 1 (the center of FIG. 4(A) or the right side surface) has the most projected section approximately from an upper surface and the insertion support portion 11, and the amount of the projection around the lower portion of the connection portion at the lower side, the engagement protrusion 13 and the other side surface side end of the bottom portion 14 is greater than the most projected section and less than that of the section around the above-mentioned insertion support portion 11. As such, when the other side surface sides of the adjacent frames 1 are connected to each other, as shown in FIG. 1, sections from the upper surfaces to the insertion support portions 11 of the frames 1 are in contact with each other, and the sections located lower than those sections in contact have a clearance between the contacting frames 1. Here, the end of the other side surface side of the engagement protrusion 13 is positioned more toward the first side surface side than the bottom portion 14.

Also, as shown in the illustrations, there is a C-shaped chamfer on an upper portion of the open side of the connection portion 12 of the frame 1, and the C-shaped chamfer makes the upper portion of the opening of the connection portion 12 incline. Also, an end of the lower portion of the open side of the connection portion 12 of the frame 1 and an end of the other side surface side of the bottom portion 14 are bent together to face each other where these other side surface side ends are positioned on an almost flush surface line (i.e., the amount of projection at the other side surface side is the same). Then, the frame 1 has screw holes at an inner side of the other side surface side between the insertion support portion 11, the connection portion 12, and an inner side of one side surface side between the engagement protrusion 13 and the bottom portion 14, which can be used to assemble the frames 1 to build a framework. Here, the material of the frame 1 is an aluminum extruded material with the same cross-section shapes, and colors thereof can be black, silver, brown, etc.

In addition, in this embodiment as shown in FIG. 3, the module glasses 6 has a pair of facing sides (downward incline side and upward incline side) where the frames 1 are fastened, and side surface frames 10, 10a are fastened on sides orthogonal to the pair of facing sides, where the side surface frames 10, 10a are fastened at the ends of the frames 1 by frame fastening screws 10e. As such, the frames 1 and the side surface frames 10, 10a are fastened around the rectangular module glasses 6, thereby forming the rectangular solar cell module. Here, in this example, the frames 1 and the side surface frames 10, 10a have different cross-section shapes.

On one hand, the holding member 2 comprises a pair of connecting portions 21 which can be inserted in the connection portions 12 of the frames 1 and extending in the direction spreading apart from each other; a downward section 22 extending downward from around the middle portions of the pair of connecting portions 21; and a seat section 24 arranged at a lower end of the downward section 22 and capable of mounting the bottom portion 14 of the frame 1 thereon. Also, the holding member 2 has a connecting portion 23 which extends leftward from the downward section 22 between the connecting portion 21 and the seat section surface 24a, and has an arrow-shaped end 23a with its end projecting downward. This seat section 24 has a rectangular section at the right lower side from a connecting point with the downward section 22 and a C-shaped portion at a left lower side with an opening at the lower side whose size is almost equal to the right lower side rectangle. Also, the seat section surface 24a can mount the bottom portion 14 of the frame 1 thereon and has a waterproof rubber 3 (e.g., butyl rubber), which gives a waterproof effect and corresponds to the rough surface (convex-concave surface) of the roof material 4, attached at a lower side of a seat section lower surface 24b. Furthermore, the holding member 2 has a holding portion 25, which extends in the opposite direction away from the connecting portion 23 from the seat section lower surface 24a so as to hold the supporting member 42.

This holding member 2 is formed in an almost T shape by a pair of the connecting portions 21 and the downward section 22 and is designed to adjoin the end of the opening side lower portion of the connection portion 12 of the frame 1 and the other side surface side end of the bottom portion 14 at the side surface of the downward section 22, where the frame 1 has its movement restricted toward the other side surface side by the downward section 22. Also, the C-shaped chamfer is formed at an angled portion of the end lower side of the connecting portion 21, and the C-shaped chamfer makes the end lower side of the connecting portion incline. Here, the material of the frame 2 is an aluminum extruded material with the same cross-section shapes, and colors thereof can be black and silver. In addition, the length of the holding member 2 is preferably between 100 mm - 200 mm relative to the extrusion direction, and the holding member 2 is designed shorter than the frame, thereby allowing it to slide.

As such, the height adjustment can be done by the adjacent roof materials between the seat section surface 24a of the seat section 24 of the holding member 2 and the seat section lower surface 24b. For example, a flat roof made from asphalt shingle or straight roof material can be arranged to be lowered for a module cable 61 (FIG. 1) to pass through, and the distance/height between the roof material 4 and the bottom surface 14 of the frame 1 can be 7 mm. Also, the surfaces of the adjacent roof materials 4a and the frames 1 can have approximately the same height when the roof materials 4a are thicker, such as roof tiles, where adjusting the height gives the feeling of integrity with the building and improves the design.

Then, the installation process of the solar cell module using the frame 1 and the holding member 2 for the solar cell module of this embodiment will be explained with reference to FIGS 1-4. At first, as shown in FIG. 1, the starter fixture 2a functioning as the holding member 2 is fastened to the supporting member 42, such as a roof, and the first solar cell module is arranged at the downward incline side (opposite to the upward incline side) where the frame 1 of one side (upward incline side) of the first solar cell module is connected to the starter fixture 2a. Then, the holding member 2 is connected to the side (downward incline side) opposite to the side where the starter fixture 2a is connected. At that time, the holding portion 25 of the holding member 2 fastened to the supporting member 42 connected to the frame 1 of the solar cell module so as to face the direction of the side opposite to the solar cell module. Then, the holding member 2 can be slid relative to the frame 1 to fasten the position of the holding member 2 on the supporting member 42 supporting the sheathing slope 41 with the predetermined intervals, thereby fastening the first solar cell module to the supporting member 42.

Next, relative to the holding member 2 which fastens the first solar cell module, the frame 1 at the upward incline side of the second solar cell module is connected at the downward incline side thereof. Accordingly, two adjacent frames 1 of the solar cell modules are in contact with each other, and the holding members 2 are fastened to the supporting members 42 at the lower side of the second solar cell module. Afterward, in the second solar cell module, the holding member 2 is fastened to the frame 1 at the other side (downward incline side), and as stated above, the holding member 2 is fastened to the supporting member 42 so as to completely fasten the second solar cell module, wherein the above-mentioned operation can be repeated to fasten the solar cell modules to the supporting members 42 in order from the upward incline side toward the downward incline side. Accordingly, according to the solar cell modules retaining structure of this invention, relative to the supporting member 42, multiple solar cell modules can be fastened in order in one direction from a certain point (for example, the starter fixture 2a), and the standardization of the installation and installation cost reduction becomes possible.

To explain further in detail, as shown in FIG. 4 (A), the holding member 2 is approximately arranged at the position of the supporting member 42 supporting the sheathing slope 41 with the predetermined intervals, and the engagement protrusion 13 of the frame 1 and the engaging protrusion 23 of the holding member 2 are used to make an engagement in between. The engagement between engagement protrusion 13 and the engaging protrusion 23 restricts the movement in the right-angle direction relative to the extension direction of the frame 1, which enables the disengagement of the holding member 2 at the installation process and smooth sliding, thereby reducing the cost of manufacturing and assembling.

Next, as shown in FIG. 4 (B), the holding member 2 can be arranged at a position to be fastened to the supporting member 42, a separate peeling paper (not shown in the figures) of the waterproof rubber 3, corresponding to the rough surface (convex-concave surface) of the waterproof and the roof material 4 underneath the lower surface 24b of the seat section, is peeled off, and the holding member 2 is arranged on the surface of the roof material 4 at an appropriate position. Afterward, the holding member 2 is completely fastened to the supporting member 42 by a fastener 5 utilizing the holding screw hole 25a of the holding portion 25, and the solar cell module is fastened to the supporting member 42. As such, disengagement of the holding member 2 from the installed position due to an external force applied on the solar cell module (for example, wind load and earthquake load) can be prevented.

Lastly, as shown in FIG. 4 (C), after fastening the holding member 2 to the supporting member 42, a bottom end portion 14a of the bottom portion 14 of the frame 1 in the second solar cell module that goes toward the downward incline side is mounted on the seat section surface 24a of the holding member 2, and while sliding in an upward direction, the connection portion 12 of the frame 1 is inserted and connected relative to the connecting portion 21 of the holding member 2. At that time, since the seat section surface 24a at the side where the second solar cell module of the holding member 2 is mounted is longer than the length of the connecting portion 21, the bottom end portion 14a of the bottom portion 14 of the frame 1 can easily be mounted on the seat section surface 24a. Furthermore, since a portion of the frame 1 at the open side upper portion of the connection portion 12 inclines while a portion of the holding member 2 at the lower end side of the connecting portion 21 inclines, when the connection portion 12 is connected to the connecting portion 21, the solar cell module does not interfere even if it slants, which allows these members to be slanted as they are connected, thereby providing and easy and cost-saving installation.

Then, FIG. 5 (A) illustrates an example of installation where the solar cell module retaining structure described above is arranged on the roof material 4 (such as a thinner roof material such as asphalt shingle or straight roof material). Height adjustment between the seat section surface 24a of the seat section 24 of the holding member 2 and the seat section lower surface 24b thereof can be operated, and the position where the module cable passes can be lowered to arrange the height between the roof material 4 and the lower surface of the bottom portion 14 of the frame 1 to be 7 mm, which gives the feeling of integrity with the building and improves the design.

Also, FIG. 5 (B) illustrates an example of an installation where the surface of the frame 1 of the above-mentioned solar cell module retaining structure and the surface of the adjacent roof material 4a (for example, a thicker roof material such as roof tiles) are almost the same height. As stated above, the height of the seat section surface 24a of the seat section 24 of the holding member 2 and the seat section lower surface 24b can be adjusted, and with respect to the roof material 4a with thicker adjacent roof material, such as roof tiles, since the surfaces of the adjacent roof materials 4a and the frames 1 can have approximately the same height, adjusting the height gives the feeling of integrity with the building and improves the design.

Also, with respect to the solar cell module retaining structure, as shown in FIGS. 3 (B) and 3 (C), instead of the side surface frame 10 different side surface frames 10a can have notched grooves 10d through which the holding member 2 can pass at both sides of the solar cell module, and while the solar cell modules with side surface 10a are joined and fastened on the roof material 4 by the holding member 2, the side surface cap 10b can be used to cover and close the facing notched grooves 10d of the side surface frames 10a. In addition, the side surface cap 10b can be aluminum or a color steel plate (such as a galbarium steel plate), with the frame 1 and the side surface frame 10a having the same color.

To explain more in detail, as shown in FIG. 3 (C), while the size of the side surface cap 10e is arranged in order to sufficiently cover the facing notched grooves 10d, the size of the notched groove 10d of the side surface frame 10a is arranged so that the connecting portion 21 of the holding member 2 and the engaging protrusion 23 do not interfere. Then, the side surface cap 10b can be attached to the frame 1 using a portion of the frame fastening screw 10e in order to bridge two solar cell modules.

After the notched grooves 10d of the side surface frames 10a and the side surface cap 10b are used to fasten and place the solar cell modules on the roof material 4, by removing the side surface cap 10e and sliding the solar cell modules laterally (in an extending direction of the frame 1) using the engagement function between the engagement protrusion 13 of the frame 1 and the engaging protrusion 21 of the holding member 2, the solar cell modules can be removed from the holding members 2 through the notched grooves 10d when maintenance of the solar cell modules is being performed. As such, during a normal installation process, the arrangement of the side surface cap 10b increases the design of the solar cell modules and prevents the horizontal/lateral disengagement of the solar cell modules, and when maintenance after installing the solar cell module is necessary, the solar cell modules can be removed without removing the holding member 2 from the roof material 4, and it is possible to perform the maintenance operation and reduce the risk of breaking the roof material 4 and leakage.

As stated above, according the solar cell module retaining structure with the frame 1 and the holding member 2 of the solar cell module of this embodiment, the number of members relating to the solar cell module retaining structure can be reduced and standardizing the installation process is possible, which reduces the cost of manufacturing and installation, and improves the design thereof.

Also, the holding member 2 can slide freely relative to the frame 1, and therefore the holding member 2 can be positioned on the supporting member 42 supporting the sheathing slope 31 with the predetermined intervals, and the fastener 5 can be used to firmly fasten the solar cell module.

In addition, after fastening the solar cell modules with the holding members 2 via the frames 1, the solar cell modules of the downward incline side can be fastened with the holding members 2. At that time, the holding portion 25 of the holding member 2 to be fastened at the supporting member 42 is fastened at the supporting member 42 at the lower side of the solar cell module at the downward incline side, thereby making the frames 1 come in contact with each other. Furthermore, the solar cell modules are connected to make an almost flush surface, which improves the design without using a member such as a cover. Also, since the frames 1 of the solar cell modules arranged adjacent to each other are connected to each other, as long as the solar cell modules are the same size, an installation surface of the solar cell module can be minimized, thereby preventing the reduction of the number of installations of the solar cell modules on roofs, etc.

Furthermore, since the frames 1 are designed to have matching cross-section surfaces with two facing sides of the solar cell module, the frames 1 with different cross-section surface shapes are not necessary for the solar cell module to be fastened to the supporting member, which reduces the number of parts, cutting down the manufacturing cost of the solar cell module retaining structure.

Also, by using the insertion support portion 11 of the frame 1 and the insertion support portion of the side surface frame 10, a conventional module glass 6 (solar cell panel body) with solar cells can be inserted and supported.

Furthermore, since adjacent solar cell modules can be joined with the side surface caps 10b, one solar cell module and the adjacent other solar cell module can be electrically connected via the side surface cap 10b and the frame holding screw 10e, and therefore, there is no need to separately install the cables for groundings and prepare additional parts for the groundings when installing groundings between the solar cell modules, and the solar cell modules can easily be connected each other, which reduces the cost in relation to the grounding.

Up to now, although the preferred embodiments of this invention were explained, this invention is not limited to the above-mentioned embodiments, and as shown in the following sections, various improvements and modification of the design are possible without departing from the scope of this invention.

That is, in the above embodiments, the screw hole for fastening the side surface frame 10a of the frame 1 is also used to install the side surface cap 10b; however, as shown in FIGS. 6 (A) - 6 (C), the screw hole 14b for the side surface cap can be created on the frame 1 e, and the side surface cap 10c can be fastened by the side surface cap holding screw 10f. Furthermore, the side surface cap 10c is sized to be in the notched grooves 10d of the facing side surface frames 10a and has the same height as the side surface frames 10a, which improves the design thereof. Furthermore, when the maintenance operation is necessary, there is no need for the frame holding screw 10e for fastening the frames 1 and the side surface frames 10a to be loosened, removing the possibility of loosening the frame connections. Also, the side surface cap holding screw 10f is required; however, as shown in FIG. 6 (C), the frame holding screw 10e and the side surface cap holding screw 10f are clearly separated, which provides better maintenance access and eliminates the chance of mistaking the removal screw.

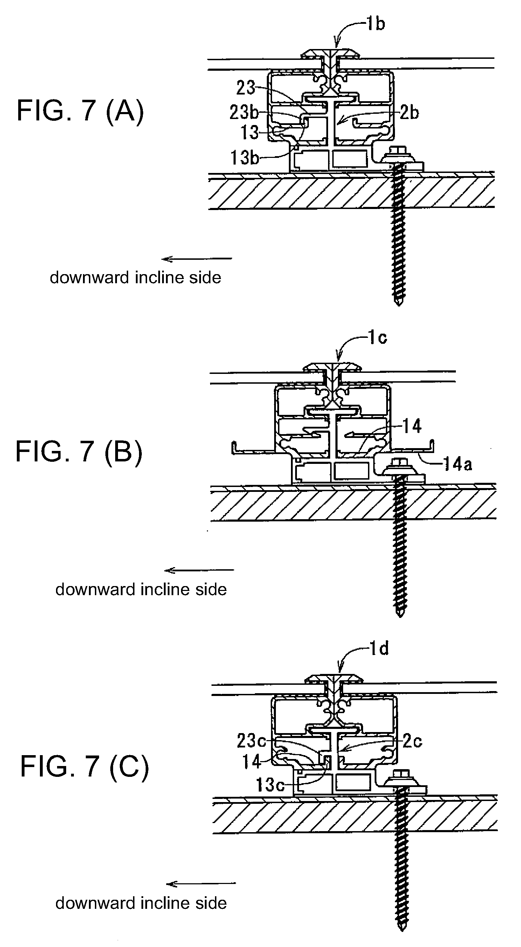

Also, in the description above, the engagement protrusion 13 of the frame 1 has an arrow-shaped end portion 13a with a projecting top on the frame 1 and the engaging protrusion 23 has the arrow-shaped end portion 23a with projecting lower end on the holding member 2; however, this invention is not limited thereto, and L-shaped end 13b as in FIG. 7 (A) and the L-shaped end 23b are possible. Concretely, the L-shaped end 13b of the engagement protrusion 13 and the L-shaped end 23b of the engaging portion 23 provide firmer engagement than the arrow-shaped engagement. In the normal installation process, the holding member 2 is arranged at an approximate position on the supporting member 42 supporting the sheathing slope 41 with the predetermined intervals, and the engagement protrusion 13 of the frame 1 and the engaging protrusion 23 of the holding member 2 are used to make an engagement in between; however, when installing on a vertical/perpendicular wall, the load on the engagement protrusion 13 and the engaging protrusion 23 increases. Accordingly, the L-shaped end 13b of the frame 1b and the L-shaped end 23b of the holding member 2b provide a firmer engagement force.

Furthermore, as shown in FIG. 7 (B), the frame 1c can be equipped with an extending piece 14a extending to an opposite side of the bottom portion 14 of the frame. The extending piece 14a increases the strength of the frame 1c against the deflection compared to the frame 1 with respect to X direction (the direction along the supporting member) and Y direction (the right-angle direction facing the supporting member). For example, a stronger frame 1 is necessary when installing the solar cell module in a snowy area or an area that often encounters strong gusts of wind. The extending piece 14a functions as the reinforcement part for the frame 1.

Also, in the above-mentioned embodiments, the engagement protrusion 13 has an arrow-shaped end portion 13a around the center of the connection portion 12 and the bottom portion 14, extending in the same direction as the bottom portion 14 and having an arrow projecting top, and the engaging protrusion 23 has an arrow-shaped end portion 23a, extending to the left side from the down portion 22 between the connecting portion 21 and the seat section surface 24a and having the projecting lower end; however, this invention is not limited thereto, and as shown in FIG. 7 (C), the L-shaped end 13c and the L-shaped end 23c are possible. Concretely, the L-shaped end portion 13c can be located at the end of the bottom portion 14 of the frame 1, and the engaging portion 23 of the holding member 2 can engage the L-shaped end portion 23c. Accordingly, unlike the frame 1, there is no need for the engagement protrusion 13, and the functions of the bottom portion 14 and the engagement protrusion can be shared, reducing the necessary area space and the cost of frame 1.

## Claims

1. A solar cell module retaining structure for fastening a solar cell module to a supporting member (42), wherein
the solar cell module includes a solar cell panel body (6) whose shape is flat and constituted by a plurality of edges, the solar cell panel body including a solar cell and frames (1) to be fastened to at least one pair of facing edges of the solar cell panel bodies adjacent to each other, and whereby, the solar cell module is capable of being fastened to the supporting member by connecting each of holding members (2) to the frames fastened respectively to the pair of facing edges of the solar cell panel bodies adjacent to each other, and by fastening each holding member to the supporting member, wherein
each of the holding members is slidable relative to the frames and: connects the two solar cell modules arranged in an extending direction of the supporting member such that the frames of the solar cell panel bodies of the two solar cell modules are adjacent to each other, and such that the two solar cell modules make substantially a flush surface; and wherein each of the holding members further restricts movement of one of the two solar cell modules in a direction perpendicular to an extending direction of the frames; and is fastened to the supporting member below the other of the two solar cell modules, and wherein
the frame, configured to extend in a longitudinal direction while having the same cross-section in a longitudinal direction, comprises:
a C-shaped insertion support portion (11) having an opening of the C-shape at one side, the edge of the solar cell panel body capable of being inserted into the C-shaped insertion support portion, and supported by the C-shaped insertion support portion;
a connection portion (12) arranged below the C-shaped insertion support portion and having an opening at the other side opposite to the one side; and
an engagement protrusion (13) arranged below the connection portion and having an opening at the other side, an end portion (13a) of the engagement protrusion projecting upward, and
the holding member, configured to be shorter than the frame in a longitudinal direction while having the same cross-section in a longitudinal direction, the holding member further comprising :
a pair of connecting portions (21) capable of being inserted in the connection portion and extending in a direction away from each other;
a down section (22) extending downward from the pair of the connecting portions;
a seat section (24) arranged at the lower end of the down section and capable of having a bottom of the frame mounted thereon;
an engagement piece (23) arranged on the down section between the seat section and the connecting portion, and extending from the down section in the same direction as a direction of the connecting portion, the engagement piece having an engagement protrusion portion (23a) projecting downward so as to engage the engagement protrusion of the frame; and
a holding portion (25) having a bottom surface on the same surface as a bottom surface of the seat section and extending in a direction opposite to a direction of the engagement piece so as to be fastened to the supporting member.

2. The solar cell module retaining structure according to Claim 1, wherein
the other solar cell module is placed on a roof sloping on a downward incline side thereof, with the holding member (2) in between.

3. The solar cell module retaining structure according to Claim 1, wherein
the top of the frame (1) inclines at the open side of the connection portion (21) thereof, and a portion of the holding member (2) inclines at the lower side of the end of the connecting portion.

4. The solar cell module retaining structure according to Claim 1, further comprising
a side surface frame (10a) that is fastened to a side different from a side where the frame (1) is fastened around the solar cell panel body, has a notched groove (10d) through which the holding member (2) can pass, a side surface cap (10b) that covers the notched groove of the side surface frame, and is fastened to the frame, wherein
by removing the side surface cap while the holding member is supported by the supporting member (42), the solar cell module fastened by the holding member can be slid in the extending direction of the frame to remove the solar cell module from the holding member.

5. A holding member (2) for the solar cell module retaining structure of Claim 1, to be fastened to a predetermined supporting member of the solar cell module via a frame extended lengthwise in a cross-section and configured to be shorter than the frame in a longitudinal direction while having the same cross-section in a longitudinal direction, comprising:
a pair of connecting portions (21) capable of being inserted in the connection portion and extending in a direction away from each other;
a down section (22) extending downward from the pair of the connecting portions;
a seat section (24) arranged at the lower end of the down section and capable of having a bottom of the frame mounted thereon;
an engagement piece (23) arranged on the down section between the seat section and the connecting portion, and extending from the down section in the same direction as a direction of the connecting portion, the engagement piece having an engagement protrusion portion (23a) projecting downward so as to engage the engagement protrusion of the frame; and
a holding portion (25) having a bottom surface on the same surface as a bottom surface of the seat section and extending in a direction opposite to a direction of the engagement piece so as to be fastened to the supporting member.

6. The holding member according to Claim 5, wherein the seat section (24) extends farther than the extension of the connection portion (12).

7. The holding member according to Claims 5 or 6, wherein height thereof is designed for said seat section (24) to sufficiently form a clearance between the lower surface of the frame (1) and the supporting member (42), through which a module cable connected to the solar cell panel body can pass, and the upper surface of the solar cell module body is adjustable so that height thereof is approximately equal to a roof material mounted on the supporting member.

## Patentansprüche

1. Solarzellenmodulhaltestruktur zum Befestigen eines Solarzellenmoduls an einem Trägerelement (42), wobei
das Solarzellenmodul einen Solarzellenpanelkörper (6) umfasst, dessen Gestalt flach ist und aus einer Vielzahl von Kanten besteht, wobei der Solarzellenpanelkörper eine Solarzelle und Rahmen (1) umfasst, um an mindestens einem Paar von gegenüberliegenden Kanten der nebeneinanderliegenden Solarzellenpanelkörper befestigt zu werden, und wobei das Solarzellenmodul in der Lage ist, am Trägerelement durch Verbinden eines jeden der Halteelemente (2) mit den Rahmen, die jeweils an dem Paar von gegenüberliegenden Kanten der Solarzellenpanelkörper, die nebeneinander liegen, befestigt sind, und durch Befestigen eines jeden Halteelements an dem Trägerelement, befestigt zu werden, wobei
jedes der Halteelemente relativ zu den Rahmen verschiebbar ist und die zwei Solarzellenmodule verbindet, die in einer Ausdehnungsrichtung des Trägerelements so angeordnet sind, dass die Rahmen der Solarzellenpanelkörper der beiden Solarzellenmodule nebeneinanderliegen, und so, dass die beiden Solarzellenmodule im Wesentlichen eine bündige Oberfläche ergeben;
und wobei jedes der Halteelemente weiterhin
die Bewegung von einem der beiden Solarzellenmodule in einer Richtung senkrecht zu einer Ausdehnungsrichtung der Rahmen einschränkt; und an dem Trägerelement unterhalb des anderen der beiden Solarzellmodule befestigt ist, und wobei
der Rahmen, der konfiguriert ist, um sich in einer Längsrichtung zu erstrecken, während er in einer Längsrichtung den gleichen Querschnitt aufweist, folgendes umfasst:
ein C-förmiges Einsatzträgerstück (11) mit einer Öffnung der C-Form auf einer Seite, wobei die Kante des Solarzellenpanelkörpers in der Lage ist, in das C-förmige Einsatzträgerstück eingesetzt zu werden, und durch das C-förmige Einsatzträgerstück getragen wird;
ein Verbindungsstück (12), das unterhalb des C-förmigen Einsatzträgerstücks angeordnet ist, und mit einer Öffnung auf der anderen Seite gegenüber von der einen Seite; und
einen vorstehenden Eingriffsteil (13), der unterhalb des Verbindungsstücks angeordnet ist, und mit einer Öffnung auf der anderen Seite, wobei ein Endstück (13a) des vorstehenden Eingriffsteils nach oben ragt, und
das Halteelement, das konfiguriert ist, um in einer Längsrichtung kürzer zu sein als der Rahmen, während es in einer Längsrichtung den gleichen Querschnitt aufweist, wobei das Halteelement weiterhin folgendes umfasst:
ein Paar von Verbindungsstücken (21), die in der Lage sind, in das Verbindungsstück eingesetzt zu werden und die sich in einer Richtung voneinander weg erstrecken;
einen nach unten verlaufenden Abschnitt (22), der sich von dem Paar der Verbindungsstücke nach unten erstreckt;
einen Aufsitzabschnitt (24), der am unteren Ende des nach unten verlaufenden Abschnitts angeordnet ist und in der Lage ist, dass sich daran eine Unterseite des Rahmens befestigen lässt;
ein Eingriffselement (23), das an dem nach unten verlaufenden Abschnitt zwischen dem Aufsitzabschnitt und dem Verbindungsstück angeordnet ist und sich von dem nach unten verlaufenden Abschnitt in der gleichen Richtung erstreckt wie eine Richtung des Verbindungsstücks, wobei das Eingriffselement einen vorstehenden Eingriffsteil (23a) aufweist, der nach unten ragt, so dass er in den vorstehender Eingriffsteil des Rahmens eingreift; und
einen Halteteil (25) mit einer unteren Fläche auf der gleichen Fläche wie eine untere Fläche des Aufsitzabschnitts und sich in einer Richtung entgegengesetzt zu einer Richtung des Eingriffelements erstreckend, so dass er an dem Trägerelement befestigt ist.

2. Solarzellenmodulhaltestruktur nach Anspruch 1, wobei
das andere Solarzellenmodul an einer Dachschräge auf einer nach unten geneigten Seite davon mit dem Haltelement (2) dazwischen angeordnet ist.

3. Solarzellenmodulhaltestruktur nach Anspruch 1, wobei
die Oberseite des Rahmens (1) sich auf der offenen Seite des Verbindungsstücks (21) davon neigt, und sich ein Teil des Halteelements (2) auf der unteren Seite des Endes des Verbindungstücks neigt.

4. Solarzellenmodulhaltestruktur nach Anspruch 1, die weiterhin folgendes umfasst:
einen Seitenflächenrahmen (10a), der an einer Seite verschieden von einer Seite befestigt ist, an der der Rahmen (1) um den Solarzellenpanelkörper herum befestigt ist, der Kerbrillen (10d) aufweist, die das Halteelement (2) passieren kann, eine Seitenflächenkappe (10b), die die Kerbrillen des Seitenflächenrahmens abdeckt und an dem Rahmen befestigt ist, wobei
durch Entfernen der Seitenflächenkappe, während das Haltelement von dem Trägerelement (42) getragen wird, das durch das Halteelement befestigte Solarzellenmodul in der Ausdehnungsrichtung des Rahmens verschoben werden kann, um das Solarzellenmodul von dem Haltelement zu entfernen.

5. Haltelement (2) für die Solarzellenmodulhaltestruktur nach Anspruch 1 zur Befestigung an einem vorbestimmten Trägerelement des Solarzellenmoduls über einen Rahmen, der in einem Querschnitt längsweise erweitert ist und der konfiguriert ist, um kürzer zu sein als der Rahmen in einer Längsrichtung, während er in einer Längsrichtung den gleichen Querschnitt aufweist, das folgendes umfasst:
ein Paar von Verbindungsstücken (21), die in der Lage sind, in das Verbindungsstück eingesetzt zu werden, und die sich in einer Richtung voneinander weg erstrecken;
einen nach unten verlaufenden Abschnitt (22), der sich von dem Paar der Verbindungsstücke nach unten erstreckt;
einen Aufsitzabschnitt (24), der am unteren Ende des nach unten verlaufenden Abschnitts angeordnet ist und in der Lage ist, dass sich daran eine Unterseite des Rahmens befestigen lässt;
ein Eingriffselement (23), das an dem nach unten verlaufenden Abschnitt zwischen dem Aufsitzabschnitt und dem Verbindungsstück angeordnet ist und sich von dem nach unten verlaufenden Abschnitt in der gleichen Richtung erstreckt wie eine Richtung des Verbindungsstücks, wobei das Eingriffselement einen vorstehenden Eingriffsteil (23a) aufweist, der nach unten ragt, so dass er in den vorstehenden Eingriffsteil des Rahmens eingreift; und
einen Halteteil (25) mit einer unteren Fläche auf der gleichen Fläche wie eine untere Fläche des Aufsitzabschnitts und sich in einer Richtung entgegengesetzt zu einer Richtung des Eingriffelements erstreckend, so dass er an dem Trägerelement befestigt ist.

6. Haltelement (2) nach Anspruch 5, wobei
sich der Aufsitzabschnitt (24) weiter erstreckt als die Ausdehnung des Verbindungsstücks (12).

7. Haltelement (2) nach Anspruch 5 oder 6, wobei die Höhe davon für den Aufsitzabschnitt (24) ausgelegt ist, um einen Abstand zwischen der unteren Fläche des Rahmens (1) und dem Trägerelement (42) ausreichend auszubilden, den ein Modul, das in der Lage ist, an dem Solarzellenpanelkörper befestigt zu werden, passieren kann, und die obere Fläche des Solarzellenpanelkörpers einstellbar ist, so dass die Höhe davon ungefähr gleich einem auf dem Trägerelement befestigten Dachmaterial ist.

## Revendications

1. Structure de retenue pour module de cellule solaire destinée à fixer un module de cellule solaire sur un élément de support (42), dans laquelle
le module de cellule solaire inclut un corps de panneau de cellule solaire (6) dont la forme est plane et est constituée par une pluralité de bordures, le corps de panneau de cellule solaire incluant une cellule solaire et des cadres (1) à fixer à au moins une paire de bordures face à face des corps de panneaux de cellules solaires adjacents l'un à l'autre et grâce à quoi le module de cellule solaire est capable d'être fixé sur l'élément de support en connectant chacun des éléments de maintien (2) aux cadres fixés respectivement sur la paire de bordures face à face des corps de panneaux de cellules solaires adjacents l'un à l'autre, et en fixant chaque élément de maintien à l'élément de support, dans laquelle chacun des éléments de maintien est capable de coulisser par rapport au cadre et connecte les deux modules de cellules solaires agencés dans une direction d'extension de l'élément de support de telle façon que les cadres des corps de panneaux de cellules solaires des deux modules de cellules solaires soient adjacents l'un à l'autre, et de telle façon que les deux modules de cellules solaires réalisent sensiblement une surface en affleurement ; et dans laquelle chacun des éléments de maintien restreint en outre le mouvement de l'un des deux modules de cellules solaires dans une direction perpendiculaire à une direction d'extension des cadres ; et est fixé sur l'élément de support au-dessous de l'autre des deux modules de cellules solaires, et dans laquelle
le cadre, configuré pour s'étendre dans une direction longitudinale tout en ayant la même section transversale dans une direction longitudinale, comprend :
une portion de support d'insertion en forme de C (11) ayant une ouverture en forme de C sur un côté, la bordure du corps de panneau de cellule solaire capable d'être inséré dans la portion de support d'insertion en forme de C, et supportée par la portion de support d'insertion en forme de C ;
une portion de connexion (12) agencée au-dessous de la portion de support d'insertion en forme de C et ayant une ouverture sur l'autre côté opposé au premier côté ; et
une projection d'engagement (13) agencée au-dessous de la portion de connexion et ayant une ouverture sur l'autre côté, une portion terminale (13a) de la projection d'engagement se projetant vers le haut, et
l'élément de maintien, configuré pour être plus court que le cadre dans une direction longitudinale tout en ayant la même section transversale dans une direction longitudinale, l'élément de maintien comprenant en outre :
une paire de portions de connexion (21) capables d'être insérées dans la portion de connexion et s'étendant dans une direction en éloignement l'une de l'autre ;
une section descendante (22) s'étendant vers le bas depuis la paire de portions de connexion ;
une section formant siège (24) agencée à l'extrémité inférieure de la section descendante et capable de recevoir un fond du cadre monté sur elle-méme ;
une pièce d'engagement (23) agencée sur la section descendante entre la section formant siège et la portion de connexion, et s'étendant depuis la section descendante dans la même direction qu'une direction de la portion de connexion, la pièce d'engagement ayant une portion d'engagement en projection (23a) qui se projette vers le bas de manière à engager la projection d'engagement de cadre ; et
une portion de maintien (25) ayant une surface inférieure sur la même surface qu'une surface de fond de la section formant siège et s'étendant dans une direction opposée à une direction de la pièce d'engagement de manière à être fixée sur l'élément de support.

2. Structure de retenue pour module de cellule solaire selon la revendication 1, dans laquelle
l'autre module de cellule solaire est placé sur une toiture en pente, sur un côté de celle-ci incliné vers le bas, avec l'élément de maintien (2) entre eux.

3. Structure de retenue pour module de cellule solaire selon la revendication 1, dans laquelle
le sommet du cadre (1) est incliné du côté ouvert de la portion de connexion (21) de celui-ci, et une portion de l'élément de maintien (2) est inclinée sur le côté inférieur de l'extrémité de la portion de connexion.

4. Structure de retenue pour module de cellule solaire selon la revendication 1, comprenant en outre
un cadre de surface latérale (10a), qui est fixé sur un côté différent d'un côté où le cadre (1) est fixé autour du corps du panneau de cellule solaire, comporte une gorge en encoche (10d) à travers laquelle peut passer l'élément de maintien (2), un capuchon de surface latérale (10b) qui couvre la gorge en encoche du cadre de surface latérale, et qui est fixé au cadre, dans laquelle
en supprimant le capuchon de surface latérale alors que l'élément de support est supporté par l'élément de support (42), le module de cellule solaire fixé par l'élément de maintien peut être glissé dans la direction d'extension du cadre pour enlever le module de cellule solaire vis-à-vis de l'élément de maintien.

5. Élément de maintien (2) pour la structure de retenue pour module de cellule solaire selon la revendication 1, destinée à être fixée sur un élément de support prédéterminé du module de cellule solaire via un cadre qui s'étend dans le sens de la longueur dans une section transversale, et configuré pour être plus court que le cadre dans une direction longitudinale tout en ayant la même section transversale dans une direction longitudinale, comprenant :
une paire de portions de connexion (21) capables d'être insérées dans la portion de connexion et s'étendant dans une direction en éloignement l'une de l'autre ;
une section descendante (22) s'étendant vers le bas depuis la paire de portions de connexion ;
une section formant siège (24) agencée à l'extrémité inférieure de la section descendante et capable de recevoir un fond du cadre monté sur elle-méme ;
une pièce d'engagement (23) agencée sur la section descendante entre la section formant siège et la portion de connexion, et s'étendant depuis la section descendante dans la même direction qu'une direction de la portion de connexion, la pièce d'engagement ayant une portion en projection d'engagement (23a) qui se projette vers le bas de manière à engager la projection d'engagement du cadre ; et
une portion de maintien (25) ayant une surface inférieure sur la même surface qu'une surface inférieure de la section formant siège et s'étendant dans une direction opposée à une direction de la pièce d'engagement de manière à être fixée à l'élément de support.

6. Élément de maintien selon la revendication 5, dans lequel
la section formant siège (24) s'étend plus loin que l'extension de la portion de connexion (12).

7. Élément de maintien selon les revendications 5 ou 6, dans lequel la hauteur de celui-ci est conçue pour ladite section formant siège (24) afin de former un jeu suffisant entre la surface inférieure du cadre (1) et l'élément de support (42), jeu à travers lequel peut passer un câble de module connecté au corps de panneau de cellule solaire, et la surface supérieure du corps de module de cellule solaire est capable d'être ajustée de sorte que sa hauteur est approximativement égale à celle d'un matériau de toiture monté sur l'élément de support.
